# EUROPEAN PATENT APPLICATION

(11) **EP 4 790 711 A1**
(43) Date of publication of application: **12.08.2026**
(21) Application number: 24884458.1
(22) Date of filing: 18.10.2024
(51) Int. Cl.: G11C 13/00

(54) **RESISTIVE RANDOM ACCESS MEMORY AND ERASING COMPILATION METHOD, CHIP, AND ELECTRONIC DEVICE**

(30) Priority: 31.10.2023 CN 202311435193
(71) Applicant: Innostar Semiconductor (Shanghai) Co., Ltd., Shanghai 201306 (CN); Innostar Semiconductor (Hangzhou) Co., Ltd., Hangzhou, Zhejiang 310000 (CN)
(72) Inventor: QIU, Shengfen, Shanghai 201306 (CN); CHEN, Liang, Shanghai 201306 (CN); LIU, Yefan, Shanghai 201306 (CN); ZHOU, Yuliang, Shanghai 201306 (CN); YANG, Yun, Shanghai 201306 (CN); CAO, Heng, Shanghai 201306 (CN); LI, Xiaobo, Shanghai 201306 (CN); NI, Jiaqi, Shanghai 201306 (CN); GAO, Fei, Shanghai 201306 (CN); ZHANG, Peng, Shanghai 201306 (CN); WANG, Yingqian, Shanghai 201306 (CN); CHANG, Kangkang, Shanghai 201306 (CN)
(74) Representative: Michalski Hüttermann & Partner mbB
(86) International application number: PCT/CN2024/125696
(87) International publication number: WO 2025/092454

(57) **Abstract**

Embodiments of the present disclosure disclose a resistive random access memory and an erasing method, a chip, and an electronic device. The erasing method for a resistive random access memory comprises: performing a first erasing operation on memory cells of the resistive random access memory; after the first erasing operation is completed and a preset time has elapsed, verifying the memory cells for which the first erasing operation is completed, to determine problematic memory cells among the memory cells for which the first erasing operation is completed; and performing a second erasing operation on the problematic memory cells. The erasing method provided in the embodiments of the present disclosure can improve the accuracy and integrity of the erasing operation, reduce the erasing failure rate, and enhance the endurance of the resistive random access memory.

## Description

### CROSS-REFERENCE TO RELATED APPLICATION

This application claims priority from Chinese patent application No. 202311435193.9 titled "RESISTIVE RANDOM ACCESS MEMORY AND ERASING OPERATION METHOD, CHIP, AND ELECTRONIC DEVICE" filed on October 31, 2023.

### TECHNICAL FIELD

Embodiments of the present disclosure relate to the technical field of memories, and particularly relate to an erasing operation method for a resistive random access memory, a resistive random access memory, a computing-in-memory (CIM) chip, and an electronic device.

### BACKGROUND OF THE INVENTION

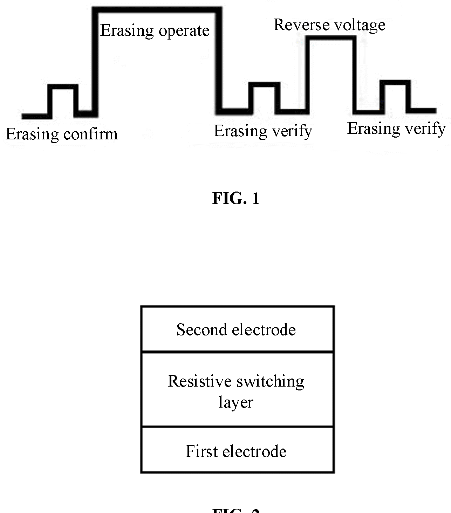

The erasing operation method for a resistive random access memory (ReRAM) typically adopts a combination of one erase pulse and one reverse write pulse. Specifically, as shown in FIG. 1, after an erase pulse is applied to a memory cell, the memory cell is verified to determine whether the erasing is successful. If the erasing is not successful, a next erase pulse is further applied and the verification is performed again. When it is verified that the erasing is successful, a reverse write pulse is applied to the memory cell to verify whether the memory cell is completely erased. If it is still verified that the erasing is successful, the writing to the memory cell is terminated. For a ReRAM cell failing to pass the verification, a next erase pulse is further applied and the verification is performed again, and then the reverse write pulse is further applied for verification after the erasing verification is successful, so on and so forth, until the erasing is successful, and then the erasing process is completed.

However, according to the filament theory of the resistive random access memory, when metal conductive filaments are thermally ruptured by the erase pulse, the resistive random access memory enters a high-resistance state. Due to the activity of metal atoms and incomplete rupture of the conductive filaments, a few metal atoms remain nearly in connection with each other or rupture points of the conductive filaments are too close to each other. As a result, after the memory cells are successfully erased and verified, the conductive filaments of a small part of the memory cells may be automatically connected after a period of time. Since the conductive filaments may automatically reconnect after rupture, this will cause incomplete erasing of the resistive random access memory, i.e., a large number of erase failure cells. As the number of usage cycles increases, the number of such failure cells will significantly increase, and greatly reduce the endurance of the resistive random access memory.

### SUMMARY OF THE INVENTION

The embodiments of the present disclosure aim to solve at least one of the technical problems existing in the prior art. Therefore, a first object of the embodiments of the present disclosure is to provide an erasing operation method for a resistive random access memory which can improve the accuracy and integrity of the erasing operation, reduce the erasing failure rate, and enhance the endurance of the resistive random access memory.

A second object of the embodiments of the present disclosure is to provide a resistive random access memory.

A third object of the embodiments of the present disclosure is to provide a computing-in-memory chip.

A fourth object of the embodiments of the present disclosure is to provide an electronic device.

To achieve the above objects, an erasing operation method for a resistive random access memory according to a first aspect of embodiments of the present disclosure comprises: performing a first erasing operation on memory cells of the resistive random access memory; after the first erasing operation is completed and a preset time has elapsed, verifying the memory cells for which the first erasing operation is completed, to determine problematic memory cells among the memory cells for which the first erasing operation is completed; and performing a second erasing operation on the problematic memory cells.

According to the erasing method for a resistive random access memory provided in the embodiments of the present disclosure, a preset waiting time is introduced after the first erasing operation is completed. Erasing verification is performed after waiting for the preset time, so that allowing sufficient time after the first erasing operation for memory cells with incompletely ruptured filaments to switch states, so that problematic memory cells can be determined more accurately. Further, a second erasing operation is performed on the problematic memory cells to ensure accurate and complete erasing, so that the failure possibility caused by overly fast operations is reduced, the erasing failure rate is lowered, and the endurance of the resistive random access memory is enhanced.

In some embodiments, a value t of the preset time satisfies 30s ≤ t ≤ 25min.

In some embodiments, the preset time has the value t = 5min.

In some embodiments, performing the first erasing operation on the memory cells of the resistive random access memory comprises: a first reset step of applying a reset voltage to the memory cells of the resistive random access memory to switch the memory cells to high resistance states; a first read step of applying a read voltage to the memory cells to detect actual resistance states of the memory cells, wherein the read voltage is lower than the reset voltage; and if the actual resistance state of a memory cell is the high resistance state, then the first erasing operation for that memory cell ends.

In some embodiments, performing the first erasing operation on the memory cells of the resistive random access memory further comprises: if the actual resistance state of the memory cell is a non-high resistance state, returning to the first reset step, and cycling through the first reset step and the first read step repeatedly until the actual resistance state of the memory cell becomes the high resistance state, or until a cycle count of cycling through the first reset step and the first read step reaches a first preset count, and then terminating the first erasing operation.

In some embodiments, verifying the memory cells for which the first erasing operation is completed, to determine problematic memory cells among the memory cells for which the first erasing operation is completed comprises: applying a read voltage to the memory cells for which the first erasing operation is completed to detect actual resistance states of the memory cells for which the first erasing operation is completed; and if the actual resistance state of a memory cell for which the first erasing operation is completed is a non-high resistance state, determining the memory cell to be a problematic memory cell.

In some embodiments, performing the second erasing operation on the problematic memory cells comprises: a second reset step of applying a reset voltage to the problematic memory cells to switch the problematic memory cells to the high resistance states; a second read step of applying a read voltage to the problematic memory cells to detect actual resistance states of the problematic memory cells; and if the actual resistance state of a problematic memory cell is the high resistance state, then ending the second erasing operation for that problematic memory cell.

In some embodiments, performing the second erasing operation on the problematic memory cells further comprises: if the actual resistance state of the problematic memory cell is a non-high resistance state, returning to the second reset step, and cycling through the second reset step and the second read step repeatedly until the actual resistance state of the problematic memory cell switches to the high resistance state, or until the cycle count of cycling through the second reset step and the second read step reaches a first preset count.

In some embodiments, a value L of the first preset count satisfies: 1 ≤ L ≤ 1000.

In some embodiments, the erasing method further comprises: before performing the first erasing operation on the memory cells of the resistive random access memory, performing a second preset count of set-reset operations on the memory cells of the resistive random access memory.

In some embodiments, in response to the second preset count greater than 1, performing the second preset count of set-reset operations on the memory cells of the resistive random access memory comprises: a set step of applying a set voltage to the memory cells to switch the memory cells to low resistance states; a third reset step of applying a reset voltage to the memory cells to switch the memory cells to high resistance states; and repeating the set step and the third reset step for the second preset count of times.

In some embodiments, a value N of the second preset count satisfies 10 ≤ N ≤ 25.

In some embodiments, the second preset count has the value N = 20.

To achieve the above objects, a resistive random access memory according to a second aspect of embodiments of the present disclosure employs the erasing method for a resistive random access memory described in the above embodiments for erasing.

According to the resistive random access memory provided in the embodiments of the present disclosure, by adopting the erasing method for a resistive random access memory described in the above embodiments, a preset waiting time is introduced after the first erasing operation is completed. Erasing verification is performed after waiting for the preset time, so that allowing sufficient time after the first erasing operation for memory cells with incompletely ruptured filaments to switch states, so that problematic memory cells can be determined more accurately. Further, a second erasing operation is performed on the problematic memory cells to ensure accurate and complete erasing, so that the failure possibility caused by overly fast operations is reduced, the erasing failure rate is lowered, and the endurance of the resistive random access memory is enhanced.

To achieve the above objects, an computing-in-memory chip according to embodiments in a third aspect of the present disclosure comprises the resistive random access memory described in the above embodiments, and the resistive random access memory comprises a plurality of memory cells.

According to the computing-in-memory chip provided in the embodiments of the present disclosure, by adopting the resistive random access memory described in the above embodiments, a preset waiting time is introduced after the first erasing operation is completed. Erasing verification is performed after waiting for the preset time, so that allowing sufficient time after the first erasing operation for memory cells with incompletely ruptured filaments to switch states, so that problematic memory cells can be determined more accurately. Further, a second erasing operation is performed on the problematic memory cells to ensure accurate and complete erasing, so that the failure possibility caused by overly fast operations is reduced, the erasing failure rate is lowered, and the endurance of the computing-in-memory chip is enhanced.

To achieve the above objects, an electronic device according to embodiments in a fourth aspect of the present disclosure comprises the computing-in-memory chip described in the above embodiments.

According to the electronic device provided in the embodiments of the present disclosure, the electronic device comprises the computing-in-memory chip described in the above embodiments, and the computing-in-memory computing chip adopts the erasing method for a resistive random access memory provided in the embodiments of the present disclosure, in which a preset waiting time is introduced after the first erasing operation is completed. Erasing verification is performed after waiting for the preset time, so that allowing sufficient time after the first erasing operation for memory cells with incompletely ruptured filaments to switch states, so that problematic memory cells can be determined more accurately. Further, a second erasing operation is performed on the problematic memory cells to ensure accurate and complete erasing, so that the failure possibility caused by overly fast operations is reduced, the erasing failure rate is lowered, and the stability and endurance of the electronic device is enhanced.

Additional aspects and advantages of embodiments of the present disclosure will be set forth in part in the description below and, in part, will be obvious from the following description, or may be learned by practice of embodiments of the present disclosure.

### BRIEF DESCRIPTION OF THE DRAWINGS

The above and /or additional aspects and advantages of the present disclosure will become apparent and readily understood from the description of embodiments with reference to the drawings below, in which:
FIG. 1 is a schematic diagram of an erasing operation method for a resistive random access memory in the prior art;
FIG. 2 is a schematic structural diagram of a resistive random access memory cell according to an embodiment of the present disclosure;
FIG. 3 is a schematic diagram showing resistance state switching of a resistive random access memory according to an embodiment of the present disclosure;
FIG. 4 is a voltage-current (V-I) characteristic diagram of a resistive random access memory according to an embodiment of the present disclosure;
FIG. 5 is a schematic diagram showing a 1T1R array in a resistive random access memory according to an embodiment of the present disclosure;
FIG. 6 is a schematic diagram showing a basic architecture of a computing-in-memory chip according to an embodiment of the present disclosure;
FIG. 7 is a flowchart of an erasing operation method for a resistive random access memory according to an embodiment of the present disclosure;
FIG. 8 is a schematic diagram showing an erase voltage and a verify voltage according to an embodiment of the present disclosure;
FIG. 9 is a schematic flowchart of an erasing operation method according to an embodiment of the present disclosure;
FIG. 10 is an overall flowchart of an erasing operation method for a resistive random access memory according to an embodiment of the present disclosure;
FIG. 11 is a block diagram of a computing-in-memory chip according to an embodiment of the present disclosure; and
FIG. 12 is a block diagram of an electronic device according to an embodiment of the present disclosure.

### Reference Signs:

electronic device 100;
computing-in-memory (CIM) chip 1;
resistive random access memory (ReRAM) 10; and
memory cell 11.

### DETAILED DESCRIPTION OF THE INVENTION

Embodiments of the present disclosure are described in detail below, the embodiments described with reference to the drawings are exemplary.

The resistive random access memory (ReRAM) is a new type of non-volatile memory that can be internally composed of a material capable of switching between different resistance states (RS). The resistance state of such materials can be adjusted with changes in an external voltage. In a resistive random access memory, the storage of data is achieved by changing the resistance state of the material (typically switching between a high resistance state and a low resistance state). Such a storage mode has the advantages of fast writing, low power consumption, high density, long life, and the like, and thus is widely studied and applied to various fields.

FIG. 2 is a schematic structural diagram of a resistive random access memory cell according to an embodiment of the present disclosure. As shown in FIG. 2, a resistive random access memory cell is an MIM structure formed by a stack of metal (second electrode) - resistive switching medium (resistive switching layer) - metal (first electrode), where the resistive switching layer is used as an ion transmission and storage medium to realize data storage by means of the resistance switching characteristic.

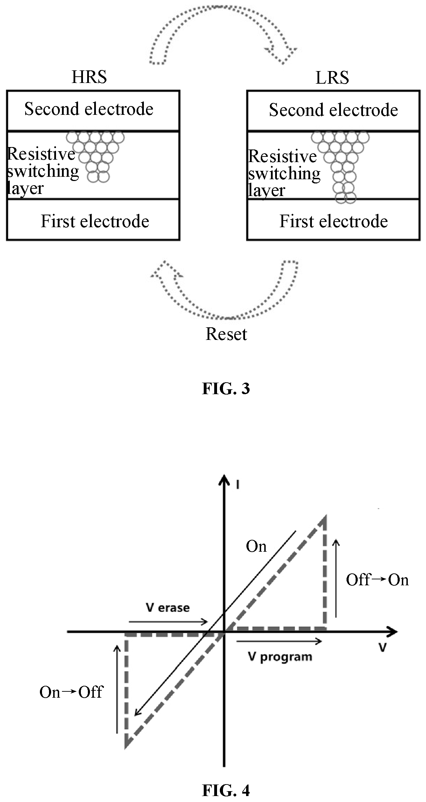

FIG. 3 is a schematic diagram showing resistance state switching of a resistive random access memory according to an embodiment of the present disclosure. As shown in FIG. 3, when a set operation is performed on a memory cell of the resistive random access memory, a conduction path is formed inside the resistive switching layer, and then, the memory cell enters a low resistance state (LRS). When a reset operation is performed on the memory cell, the conduction path in the resistive switching layer is blocked, and then the low resistance state (LRS) is switched to a high resistance state (HRS).

Therefore, the memory cell of the resistive random access memory can be switched from a high resistance state to a low resistance state by a set operation, i.e., write "1" for the storage data, and can be switched from a low resistance state to a high resistance state by a reset operation, i.e., write "0" for the storage data. The resistive random access memory stores the data 0 and 1 through such conversions between the high and low resistance states, thereby achieving the purposes of writing and erasing.

FIG. 4 is a voltage-current (V-I) characteristic diagram of a resistive random access memory according to an embodiment of the present disclosure. As shown in FIG. 4, the resistance state of the resistive random access memory varies under different voltage conditions to implement the erasing operations.

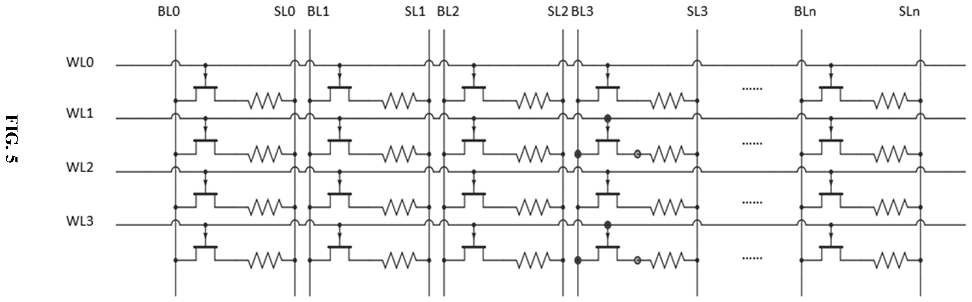

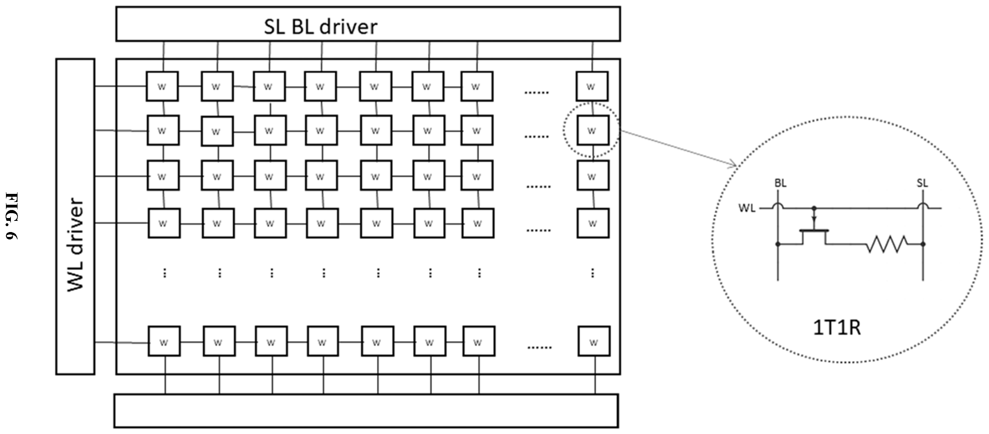

FIG. 5 is a schematic diagram showing a 1T1R array (consisting of one transistor and one resistive random access memory) in a resistive random access memory according to an embodiment of the present disclosure. FIG. 6 is a schematic diagram showing a basic architecture of a computing-in-memory chip according to an embodiment of the present disclosure, wherein the memory cell has a 1T1R structure.

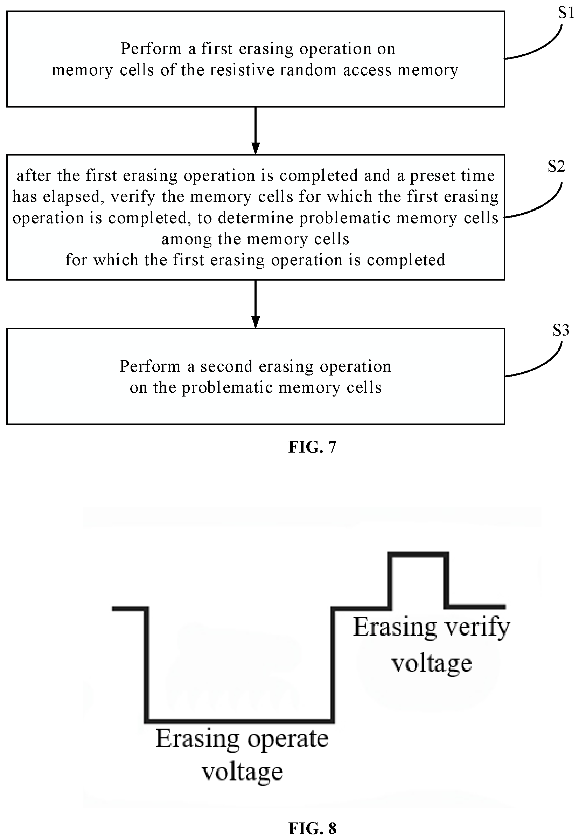

An erasing operation method for a resistive random access memory according to an embodiment of the present disclosure is described below with reference to FIG. 7.

FIG. 7 is a flowchart of an erasing operation method for a resistive random access memory according to an embodiment of the present disclosure. As shown in FIG. 7, The erasing operation method for a resistive random access memory comprises at least steps S1 to S3, which are specifically described below:

At S1, a first erasing operation is performed on memory cells of the resistive random access memory.

In some embodiments, the memory cell may be a minimum data unit in the resistive random access memory. Each memory cell comprises one variable resistance element which has a resistance state that can be switched between a high resistance and a low resistance. Each memory cell represents a one-bit (0 or 1) state. By applying a voltage or current to the memory cell, the resistance state of the material can be changed to enable the storage and reading of information.

In some embodiments, the erasing operation may refer to the operation of applying a specific erase pulse or voltage to the memory cell in the resistive random access memory to change the resistance state of the memory cell, thereby erasing information. In the erasing operation, the resistance state of the memory cell is typically changed from a low resistance state to a high resistance state to restore data in a subsequent write operation. The erasing operation is very important because it allows the memory cell to be reused for storing new information, thereby ensuring the multiple writability of the resistive random access memory.

In some embodiments, the first erasing operation on memory cells of the resistive random access memory is intended to erase data in the memory cells, but due to the material characteristics of the resistive random access memory and the influence of the external environment, some memory cells may be not completely erased after the first erasing operation is completed, leaving some residual information. Therefore, these problematic memory cells need to be processed again later.

At S2, after the first erasing operation is completed and a preset time has elapsed, the memory cells for which the first erasing operation is completed are verified to determine problematic memory cells among the memory cells for which the first erasing operation is completed.

In some embodiments, in the resistive random access memory, when metal conductive filaments are thermally ruptured by the erase pulse to enter a high resistance state, due to the activity of metal atoms plus incomplete rupture of the conductive filaments (there are still very few metal atoms close to being connected or rupture points of the conductive filaments are too close to each other), it may cause the conductive filaments of a small part of the memory cells that have been successfully erased and verified to automatically connected again after a period of time. Since the conductive filaments may be automatically connected after rupture, it may cause the problem of incomplete erasing, i.e., a large number of cells failing to be erased. Therefore, a preset waiting time is set to ensure that the memory cells have enough time to get stable after the erasing operation is completed. The system then verifies these memory cells to determine whether there are memory cells which are not completely erased after the first erasing operation.

In some embodiments, a length of the preset waiting time may be generally adjusted based on the material characteristics, environmental conditions, and equipment design. The length of the preset waiting time may affect the accuracy of the verification, and therefore should be set reasonably based on actual conditions.

In some embodiments, the verification of the memory cells for which the first erasing operation is completed generally requires the use of a read operation. The resistance state of the memory cell can be determined by applying a read voltage or current to the memory cell and measuring the corresponding resistance value. If the resistance state does not reach the expected high resistance state, it may be determined that the memory cell is a problematic memory cell. Such problematic memory cells may require further processing in a second erasing operation to ensure that they are completely erased.

At S3, a second erasing operation is performed on the problematic memory cells.

Specifically, in the second erasing operation, for the memory cells which are not completely erased after the first erasing operation, a specific erase pulse or voltage is applied again to change the resistance states of the memory cells and ensure complete erasing. The purpose of the second erasing operation is to repair the problem that some memory cells are not completely erased in the first erasing operation, and restore those memory cells to an initial state for the subsequent rewrite and read operations.

In some embodiments, parameters of the second erasing operation, such as an amplitude, width or frequency of the applied erase pulse, may be adjusted based on a verification result of the first erasing operation. Such adjustments may be implemented based on the electrical characteristics of the problematic memory cells and reasons why the first erasing operation fails to completely erase the memory cells. By finely tuning of the erase parameters, the effect of the second erasing operation can be improved to ensure that the problematic memory cells are completely erased. Meanwhile, unnecessary damage caused by an excessive erase pulse can be avoided, thereby ensuring the stability and endurance of the memory cells.

According to the erasing operation method for a resistive random access memory provided in the embodiments of the present disclosure, a preset waiting time is introduced after the first erasing operation is completed, after which erasing verification is performed, so that after the first erasing operation, there is enough time to allow memory cells with incomplete rupture of conductive filaments to switch the state, so that problematic memory cells can be determined more accurately. Further, a second erasing operation is performed on the problematic memory cells to ensure accurate and complete erasing, so that the failure possibility caused by too fast operations is reduced, the erasing failure rate is lowered, and the endurance of the resistive random access memory is enhanced.

In some embodiments, a value t of the preset time satisfies 30s ≤ t ≤ 25min. For example, the value t is 30s, or 80s, or 2min, or 5min, or 10min, or 15min, or 20min, or 25min. Such a preset time range is intended to ensure that the memory cells have enough time to get stable after the first erasing operation is completed, thereby facilitating the subsequent verify operation to determine problematic memory cells more accurately. Further, after the verify operation, the problematic memory cells can be accurately detected for the second erasing operation.

In some embodiments, the preset time may be set based on the characteristics of the resistive random access memory and the actual application requirements. Such a range is selected to balance the efficiency and accuracy of the erasing operation, and ensure that the system can achieve good performance and stability under various application scenarios. Different application scenarios may have different requirements on the response speed and the erasure accuracy. For example, in some applications with higher real-time requirements, a shorter waiting time may be required to complete the erasing operation as quickly as possible to provide a fast response. In contrast, in some application scenarios with higher requirements on stability and reliability, a longer waiting time may be required to ensure the stability of the memory cells and accurate detection of the problematic memory cells.

Therefore, the value t of the preset time satisfying 30s ≤ t ≤ 25min is determined as an applicable range, which can meet the requirements of most application scenarios while providing some flexibility for a system designer to select the appropriate waiting time based on the specific application requirements. This range is set in consideration of both universality and practicability, so that the erasing method can be effectively applied in various application scenarios.

In addition, in some special application scenarios, for example, in the aerospace field or in an extreme temperature environment, the characteristics of the resistive random access memory may vary. In such special application scenarios, the preset time may be adjusted according to actual requirements. For example, in the extreme temperature environment, the preset time may be extended to more hours to ensure that the accuracy and reliability of the erasing operation can be maintained under extreme conditions.

In some embodiments, the preset time is t = 5min. The preset time of 5min is selected based on in-depth understanding of internal characteristics of the resistive random access memory and results of experimental verification. During this time period, the memory cells have sufficient time to get stable, which can ensure that the subsequent verify and correct operations can be performed accurately and reliably, and an optimal operational result can be obtained.

Specifically, the erasing failure rate may be reduced to a very low level, e.g., 0.1*x ppm, by the first erasing operation. However, at room temperature, the erasing failure rate will continuously increase to 10*x ppm within 24 hours, which cannot meet the requirements of a chip. The problematic 10*x ppm memory cells may be further corrected by the second erasing operation, and experiments have shown that an optimal operation effect can be obtained by performing the second erasing operation 5 min later after the first erasing operation is completed, wherein the erasing failure rate can be reduced to 0.1*x ppm. Further, after the delay of 24 hours, the maximum erasing failure rate of the chip can be reduced to 0.5*x ppm, which can meet the requirement of the chip on the erasing failure rate.

In some embodiments, performing the first erasing operation on the memory cells of the resistive random access memory comprises: a first reset step and a first read step.

In the first reset step, a specific reset voltage is applied to the memory cell of the resistive random access memory. The effect of this voltage can be to switch the memory cell to a high resistance state. The high resistance state may refer to a state in which the memory cell has a very large resistance, which almost corresponds to an open circuit and hardly allows current to pass through. In this state, the memory cell is non-conductive, i.e., with no current flowing through, which may be regarded as a state in which the data is successfully erased.

Specifically, the application of the reset voltage may cause some physical or chemical changes of the resistive material in the resistive random access memory, such as a change in electronic arrangement, an adjustment of a lattice structure, and the like. Such changes increase the resistance value of the memory cell to a very high level, i.e., a high resistance state which hardly allows current to pass through. In the high resistance state, the memory cell will not make a response to a read or write operation, i.e., no longer store particular data bit, thereby achieving data erasure.

In some embodiments, the specific value of the reset voltage is related to the physical characteristics of the memory cell, and generally, in the design stage, an engineer may determine an appropriate value of the reset voltage according to the characteristics of the material and specifications of the device. The voltage value should be large enough to ensure that the resistance state of the memory cell can be reliably switched to the high resistance state and implement the erasing of data.

In some embodiments, a read voltage is applied to the memory cell to which the reset voltage has been applied, to detect an actual resistance state of the memory cell. The read voltage may be a voltage signal used to read a resistance state of a memory cell. In the resistive random access memory, this voltage is generally small enough to read a resistance value. The actual resistance state may be an actual resistance value of the memory cell at a particular voltage. Specifically, the resistance state of the memory cell is switched to a high resistance state under the action of the reset voltage. Under the action of the read voltage, the system can measure a resistance value of the memory cell. If the measured resistance value is in a high resistance range, it means that the memory cell is successfully switched to a high resistance state, and the data is erased. If the measured resistance value is not in the high resistance range, it means that the memory cell has not been switched to a high resistance state, indicating that the erasure of the memory cell is incomplete and further processing or erasing operations are required.

In some embodiments, the read voltage is lower than the reset voltage. This is because in a resistive random access memory, the reset voltage is typically a higher voltage, which is sufficient to change the resistance state of the memory cell to a high resistance state. However, in the read operation, it is not necessary to change the resistance state of the memory cell, and it is only necessary to detect a current state. Thus, by setting the read voltage to be lower than the reset voltage, it is sufficient to read the resistance value of the memory cell without changing the state of the memory cell. In this manner, the system can determine whether the memory cell is currently in a high resistance state or in a non-high resistance state, thereby facilitating subsequent operations.

In some embodiments, if the actual resistance state of the memory cell detected in the first read step is a high resistance state, it indicates that the data has been erased, so there is no need to recycle the first reset step and the first read step, and the first erasing operation ends.

In some embodiments, if the actual resistance state of the memory cell is a non-high resistance state, it indicates that the memory cell has not been completely erased, and it is necessary to return to the first reset step, and cycle the first reset step and the first read step repeatedly until the actual resistance state of the memory cell is a high resistance state, or until the number of cycles of the first reset step and the first read step reaches a first preset count, and then, terminate the first erasing operation. This indicates that the memory cell has been successfully erased, and the subsequent verifying step and programming operation can be started.

In addition, in some special application scenarios, a value of the first preset count may be adjusted to ensure complete erasing of the memory cell. For example, there may be some fluctuations in the manufacturing process, resulting in different levels of erasing quality of the memory cells. Therefore, the first preset count may be adjusted according to specific situations to ensure higher erasing quality of the memory cells and the integrity and stability of data.

In some embodiments, verifying the memory cells for which the first erasing operation is completed, to determine problematic memory cells among the memory cells for which the first erasing operation is completed comprises: applying a read voltage to the memory cells for which the first erasing operation is completed, wherein the read voltage may detect an actual resistance state of the memory cells. Therefore, by applying an appropriate read voltage, an actual resistance state of the memory cells for which the first erasing operation is completed can be detected to determine whether the actual resistance state is a high resistance state or a non-high resistance state.

Further, if the actual resistance state of a memory cell for which the first erasing operation is completed is a non-high resistance state, it indicates that the memory cell is not completely erased in the first erasing operation, and there may be previously stored data left. Then, the memory cell may be determined to be a problematic memory cell. The system may mark this memory cell as a cell requiring further processing.

Through this verification step, the system can accurately determine which memory cells are not completely erased after the first erasing operation. In this manner, the system can perform the second erasing operation in a targeted manner, thereby ensuring that all the memory cells are erased properly, and improving the accuracy and success rate of the whole erasing operation. This method guarantees the stability and reliability of the resistive random access memory in operation.

In some embodiments, performing the second erasing operation on the problematic memory cells comprises: a second reset step and a second read step.

Specifically, in the second reset step, a reset voltage is applied to the determined problematic memory cells. The reset voltage may also be a relatively high voltage to switch the problematic memory cells to a high resistance state. In the high resistance state, the memory cell is non-conductive, which may be regarded as a state in which the data is successfully erased.

Further, a read voltage is applied to the problematic memory cells to which the reset voltage has been applied, to detect an actual resistance state of the problematic memory cells. This means that by measuring a resistance value of the memory cell under the read voltage, it can be determined whether the resistance state of the memory cell is a high resistance state or a non-high resistance state.

If the actual resistance state of a problematic memory cell is a high resistance state, it means that the problematic memory cell is properly erased, and then the second erasing operation on the problematic memory cell may be ended. The memory cell is in a writable state and can be used to store new data.

In some embodiments, if the actual resistance state of a problematic memory cell is a non-high resistance state, it means that the resistance state of the problematic memory cell is not successfully switched to a high resistance state in the second erasing operation. This may be caused by internal physical or electrical characteristics of the memory cell, such as internal residual charges or special properties of the material. Since the resistance state of the memory cell does not reach the high resistance state, the cell may still retain previously stored data.

Further, in this case, the process returns to the second reset step, and the second reset step and the second read step are cycled until the actual resistance state of the problematic memory cell is switched to a high resistance state, or until the number of cycles of the second reset step and the second read step reaches a first preset count.

In some embodiments, the preset count is provided to avoid infinite loops. In other words, if the cycle number reaches the preset count and the actual resistance state of the problematic memory cell is still not switched to the high resistance state, the system may determine that the memory cell is hard to be completely erased, and there may be a hardware failure or other problems. In this case, the system may record the memory cell as unavailable to avoid affecting the stability and operating efficiency of the whole system.

Therefore, through such a cycle operation, the system may attempt to erase the problematic memory cell multiple times until its resistance state is switched to a high resistance state. This ensures complete erasing of the data in the memory cell, as well as security and reliability of the data.

In some embodiments, a value L of the first preset count satisfies: 1 ≤ L ≤ 1000. For example, L takes a value of 1 or 2 or 10 or 50 or 100 or 200 or 300 or 500 or 600 or 800 or 900 or 1000. The range of the first preset number (L) is set to ensure that the system has sufficient opportunities to attempt to erase in the event of handling an exception. Too few erase times may result in incomplete erasing of the memory cells, while too many erase times may increase the time of the whole erasing process, thereby affecting the efficiency of the operation, and wasting system resources. Therefore, by limiting the erase times within a reasonable range, the erase accuracy can be ensured while avoiding unnecessary resource waste.

In some embodiments, the value of the first preset number (L) may be determined according to characteristics of the resistive random access memory, the manufacturing process, the use environment, and the erase requirement. Generally, this value should be verified and analyzed thoroughly through experiments to ensure that the system can effectively complete the erasing operation under most circumstances.

In short, during the erasing process, wait for a preset time after the first erasing is completed, and then perform erasing verification on the memory cells to determine the problematic memory cells after the first erasing operation. As shown in FIG. 8, an erasing verify voltage is lower than an erasing operate voltage. If the erasing verification result is erasing succeeded, i.e., the memory cell is in a high resistance state, the memory cell is passed, i.e., is determined as a normal memory cell without problems; otherwise, if the erasing verification result is erasing failed, i.e., the memory cell is in a non-high resistance state, the loop cycle performs the erasing operation here. If the number of loops exceed the preset count, the memory cell is determined to be a failed memory cell, i.e., a fail cell.

In some embodiments, the erasing method further comprises: before performing the first erasing operation on the memory cells of the resistive random access memory, performing a second preset count of set-reset operations on the memory cells of the resistive random access memory, that is, performing a preset number of write + erase operations on the memory cells of the resistive random access memory, which may be referred to as a Dummy cycle in the embodiments. This means that the memory cells will be repeatedly set (to a non-high resistance state) and reset (to a high resistance state). By doing so, the memory cells can be pre-processed to eliminate potential instability, and to ensure that the memory cells can be reliably switched between states during the erasing operation.

In some embodiments, the resistance state of the memory cell is changed multiple times by the preset count of set-reset operations to ensure that internal material of the memory cell can be sufficiently stabilized upon switching of the resistance state. Therefore, in the actual erasing operation, the memory cell can be switched to the desired high-resistance state more easily and stably, thereby ensuring the erase accuracy and reducing the erasing failure rate of the initial cycle. For example, according to experimental data, with the preset count of set-reset operations, the erasing failure rate of the memory cell in the initial cycle can be reduced from the original x ppm to 0.1*x ppm.

In some embodiments, the specific value of the second preset count may be adjusted according to the characteristics and the manufacturing process of the resistive random access memory. Generally, the larger the second preset count, the higher the state stability of the memory cell, but the time required for the operation will increase accordingly. Therefore, in the determination of the specific value, an appropriate second preset count should be selected to balance the accuracy and the operating efficiency.

In some embodiments, in response to the second preset count greater than 1, performing the second preset count of set-reset operations on the memory cells of the resistive random access memory comprises: a set step and a third reset step.

Specifically, a set voltage is applied to the memory cells so that the dielectric inside the memory cells undergoes electron or ion migration, resulting in a change in the resistance state of the material. Such electric field induced resistance changes cause the memory cell to switch to a low resistance state, which indicates that the memory cell has a relatively small resistance, typically corresponding to a "1" state of the memory cell.

Further, when the memory cell is in a low resistance state, it indicates a higher charge density in the dielectric (typically a metal oxide) in the memory cell, and the resistance is relatively low, corresponding to the "1" state of the data. By applying a sufficient voltage, i.e., the reset voltage, on the memory cell, the charges can be rearranged so that the resistance state of the dielectric becomes high, thereby implementing the erasing of data, and the state of the memory cell is switched to a high resistance state, i.e., "0" state.

Further, the set step and the third reset step are repeated for the second preset count of times. This alternating operation causes the memory cell to switch between the low resistance state and the high resistance state multiple times, thereby increasing the stability of the internal material of the memory cell and ensuring reliable state switching of the memory cell.

Therefore, before the actual erasing operation, the resistance state of the memory cell becomes very stable by setting and resetting multiple times. In this manner, when the erasing operation is performed, the initial state of the memory cell has been pre-processed into a stable state, which improves the reliability and the accuracy of the erasing operation.

In some embodiments, magnitudes of the set voltage and the reset voltage may be determined according to the specific characteristics and the manufacturing process of the resistive random access memory. The magnitude and duration of the set and reset voltages need to be precisely controlled to ensure that the resistance state of the memory cell can be switched stably without damaging the memory cell or causing irreversible changes. Therefore, precise adjustment of the set and reset voltages is very important for the reliability and stability of the resistive random access memory.

In some embodiments, a value N of the second preset count satisfies 10 ≤ N ≤ 25. For example, N takes a value of 10 or 12 or 15 or 18 or 20 or 25. This value range may be based on the characteristics and actual requirements of the resistive random access memory. In practical applications, after a certain number of set-reset operations, the resistance state of the memory cell will be more stable, and the accuracy and reliability of erasing will be improved. For example, when N = 10, it indicates that 10 set-reset operations are performed to ensure that the resistance state in the memory cell is stable. Likewise, when N = 25, 25 set-reset operations are performed. The selection of the preset count is generally required to balance between performance and efficiency. Increasing the preset count may improve the reliability of erasing, but may also increase the time for the erasing operation.

In some embodiments, the second preset count has the value N = 20. This means that before the erasing operation, the memory cell needs to be set and reset for 20 times. The value is determined based on the actual requirement, the characteristics of the resistive random access memory and the application scenario. It is considered that 20 set-reset operations are sufficient to allow the resistance state of the memory cell to be stably switched prior to the erasing operation, thereby ensuring the quality of the erasing.

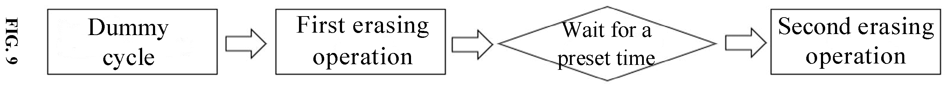

Therefore, according to the method provided in the embodiments of the present disclosure, as shown in FIG. 9, the whole erasing process may comprise a preset count of dummy cycles - the first erasing operation - wait for the preset time - the second erasing operation.

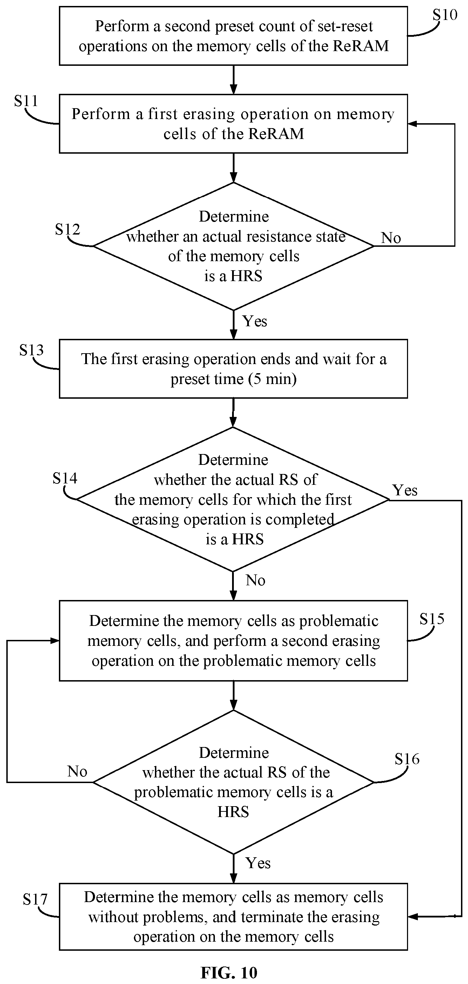

FIG. 10 is an overall flowchart of an erasing method for a resistive random access memory according to an embodiment of the present disclosure. As shown in FIG. 10, a whole flow of the erasing method for the resistive random access memory comprises at least steps S10 to S17, which are specifically described below:
At S10, performing a second preset count of set-reset operations on memory cells of a resistive random access memory.
At S11, a first erasing operation is performed on the memory cells of the resistive random access memory.
At S12, it is determined whether an actual resistance state of the memory cells is a high resistance state, if the actual resistance state of the memory cells is a high resistance state, the process proceeds to step S13, and if the actual resistance state of the memory cells is not a high resistance state, the process returns to step S11. Returning to step S11 may be performed in a loop, until the number of cycles reaches the first preset count (1000).
At S13, the first erasing operation is completed and a preset time (5 min) is waited.
At S14, it is determined whether the actual resistance state of a memory cell for which the first erasing operation is completed is a high resistance state, if the actual resistance state of the memory cell is a high resistance state, the process proceeds to step S17, and if the actual resistance state of the memory cell is not a high resistance state, the process proceeds to step S15.
At S15, the memory cell is determined as a problematic memory cell, and a second erasing operation is performed on the problematic memory cell.
At S16, it is determined whether the actual resistance state of the problematic memory cell is a high resistance state, if the actual resistance state of the problematic memory cell is a high resistance state, the process proceeds to step S17, and if the actual resistance state of the problematic memory cell is not a high resistance state, the process returns to step S15. Returning to step S15 may be performed in a loop, until the number of cycles reaches the first preset count (1000).
At S17, the memory cells are determined as memory cells without problems, and the erasing operation on the memory cells is terminated.

In summary, by introducing the first and second erasing operations, and introducing the preset waiting time after the first erasing operation is completed, and by detecting the actual resistance state of the memory cells after each erasing operation, the problem of incomplete erasing can be effectively solved to ensure accurate and complete erasing, reduce the erasing failure rate, and enhance the stability and endurance of the resistive random access memory.

An embodiment of the present disclosure further provides a resistive random access memory which is subjected to erasing in the erasing method for a resistive random access memory described in the above embodiments.

According to the resistive random access memory 10 provided in the embodiments of the present disclosure, by adopting the erasing method for a resistive random access memory described in the above embodiments, a preset waiting time is introduced when the first erasing operation is completed, after which erasing verification is performed, so that after the first erasing operation, there is enough time to allow memory cells with incomplete rupture of conductive filaments to switch the state, so that problematic memory cells can be determined more accurately. Further, a second erasing operation is performed on the problematic memory cells to ensure accurate and complete erasing, so that the failure possibility caused by too fast operations is reduced, the erasing failure rate is reduced, and the endurance of the resistive random access memory 10 is enhanced.

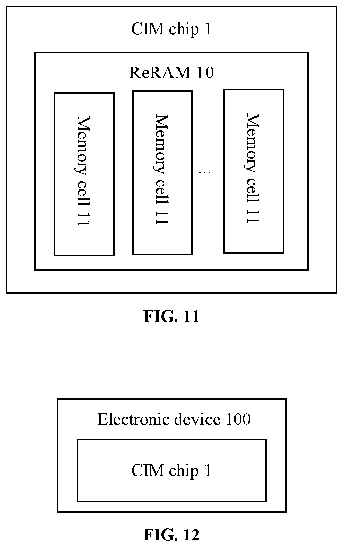

A computing-in-memory chip according to an embodiment of the present disclosure is described below with reference to FIG. 11.

FIG. 11 is a block diagram of a computing-in-memory chip according to an embodiment of the present disclosure. As shown in FIG. 11, a computing-in-memory chip 1 comprises the resistive random access memory 10 described in the above embodiments. The resistive random access memory 10 comprises a plurality of memory cells 11. This means that the computing-in-memory chip is capable of storing large-scale data, and each memory cell 11 can store one-bit data (0 or 1). The memory cells 11 adopt a resistive random access memory technology, and have the advantages of fast writing, low power consumption, high density, long life, and the like. These characteristics enable the computing-in-memory chip 1 to efficiently store and process large-scale data.

According to the computing-in-memory chip 1 provided in the embodiments of the present disclosure, by adopting the resistive random access memory 10 described in the above embodiments, a preset waiting time is introduced when the first erasing operation is completed, after which erasing verification is performed, so that after the first erasing operation, there is enough time to allow memory cells with incomplete rupture of conductive filaments to switch the state, so that problematic memory cells can be determined more accurately. Further, a second erasing operation is performed on the problematic memory cells to ensure accurate and complete erasing, so that the failure possibility caused by too fast operations is reduced, the erasing failure rate is reduced, and the endurance of the computing-in-memory chip 1 is enhanced.

In some embodiments, the computing-in-memory chip 1 may be widely applied to various scenarios requiring large-scale data storage and processing, such as the fields of artificial intelligence, big data analysis, embedded systems, and the like. The effective storage and processing capacity and the application of the erasing method ensure that the computing-in-memory chip has reliability and stability, and provide reliable hardware support for various applications.

An electronic device according to an embodiment of the present disclosure is described below with reference to FIG. 12.

FIG. 12 is a block diagram of an electronic device according to an embodiment of the present disclosure. As shown in FIG. 12, the electronic device 100 comprises the computing-in-memory chip 1 described in the above embodiments.

In some embodiments, such an electronic device 100 may be widely applied in various fields, comprising, but not limited to, smart phones, tablets, embedded systems, Internet of Things devices, and the like. The efficient data storage and processing capability and the ensured data security make the electronic device 100 more reliable and secure when handling sensitive information and large-scale data.

According to the electronic device 100 provided in the embodiments of the present disclosure, the electronic device 100 comprises the computing-in-memory chip 1 described in the above embodiments, while the computing-in-memory chip 1 adopts the erasing operation method for a resistive random access memory provided in the embodiments of the present disclosure, in which a preset waiting time is introduced when the first erasing operation is completed, after which erasing verification is performed, so that after the first erasing operation, there is enough time to allow memory cells with incomplete rupture of conductive filaments to switch the state, so that problematic memory cells can be determined more accurately. Further, a second erasing operation is performed on the problematic memory cells to ensure accurate and complete erasing, so that the failure possibility caused by too fast operations is reduced, the erasing failure rate is reduced, and the stability and endurance of the electronic device 100 are enhanced.

In the description of the specification, reference to the description of terms "one embodiment", "some embodiments", "an exemplary embodiment", "an example", "a specific example" or "some examples" or the like means that a particular feature, structure, material, or characteristic described in connection with the embodiment or example is included in at least one embodiment or example of the present disclosure. In this specification, the schematic representations of the terms used above are not necessarily intended to refer to the same embodiment or example.

While embodiments of the present disclosure have been shown and described, it will be understood by those of ordinary skill in the art that: numerous changes, modifications, substitutions and variations of these embodiments may be made without departing from the principles and spirit of the embodiments of the present disclosure, and the scope of the embodiments of the present disclosure is defined by the claims and equivalents thereof.

## Claims

1. An erasing operation method for a resistive random access memory, comprising:
performing a first erasing operation on memory cells of the resistive random access memory;
after the first erasing operation is completed and a preset time has elapsed, verifying the memory cells for which the first erasing operation is completed, to determine problematic memory cells among the memory cells for which the first erasing operation is completed; and
performing a second erasing operation on the problematic memory cells.

2. The erasing operation method for a resistive random access memory of claim 1, wherein a value t of the preset time satisfies 30s ≤ t ≤ 25min.

3. The erasing operation method for a resistive random access memory of claim 2, wherein the preset time has the value t = 5min.

4. The erasing operation method for a resistive random access memory of claim 1, wherein performing the first erasing operation on the memory cells of the resistive random access memory comprises:
a first reset step of applying a reset voltage to the memory cells of the resistive random access memory to switch the memory cells to high resistance states;
a first read step of applying a read voltage to the memory cells to detect actual resistance states of the memory cells, wherein the read voltage is lower than the reset voltage; and
if the actual resistance state of a memory cell is the high resistance state, then the first erasing operation for that memory cell ends.

5. The erasing operation method for a resistive random access memory of claim 4, wherein performing the first erasing operation on the memory cells of the resistive random access memory further comprises:
if the actual resistance state of the memory cell is a non-high resistance state, returning to the first reset step, and cycling through the first reset step and the first read step repeatedly until the actual resistance state of the memory cell becomes the high resistance state, or until a cycle count of cycling through the first reset step and the first read step reaches a first preset count, and then terminating the first erasing operation.

6. The erasing operation method for a resistive random access memory of claim 1, wherein verifying the memory cells for which the first erasing operation is completed, to determine problematic memory cells among the memory cells for which the first erasing operation is completed comprises:
applying a read voltage to the memory cells for which the first erasing operation is completed to detect actual resistance states of the memory cells for which the first erasing operation is completed; and
if the actual resistance state of a memory cell for which the first erasing operation is completed is a non-high resistance state, determining the memory cell to be a problematic memory cell.

7. The erasing operation method for a resistive random access memory of claim 1, wherein performing the second erasing operation on the problematic memory cells comprises:
a second reset step of applying a reset voltage to the problematic memory cells to switch the problematic memory cells to the high resistance states;
a second read step of applying a read voltage to the problematic memory cells to detect actual resistance states of the problematic memory cells; and
if the actual resistance state of a problematic memory cell is the high resistance state, then ending the second erasing operation for that problematic memory cell.

8. The erasing operation method for a resistive random access memory of claim 7, wherein performing the second erasing operation on the problematic memory cells further comprises:
if the actual resistance state of the problematic memory cell is a non-high resistance state, returning to the second reset step, and cycling through the second reset step and the second read step repeatedly until the actual resistance state of the problematic memory cell switches to the high resistance state, or until the cycle count of cycling through the second reset step and the second read step reaches a first preset count.

9. The erasing operation method for a resistive random access memory of claim 5 or 8, wherein a value L of the first preset count satisfies: 1 ≤ L ≤ 1000.

10. The erasing operation method for a resistive random access memory of any one of claims 1-8, wherein the erasing method further comprises:
before performing the first erasing operation on the memory cells of the resistive random access memory, performing a second preset count of set-reset operations on the memory cells of the resistive random access memory.

11. The erasing operation method for a resistive random access memory of claim 10, wherein in response to the second preset count greater than 1, performing the second preset count of set-reset operations on the memory cells of the resistive random access memory comprises:
a set step of applying a set voltage to the memory cells to switch the memory cells to low resistance states;
a third reset step of applying a reset voltage to the memory cells to switch the memory cells to high resistance states; and
repeating the set step and the third reset step for the second preset count of times.

12. The erasing operation method for a resistive random access memory of claim 11, wherein a value N of the second preset count satisfies 10 ≤ N ≤ 25.

13. The erasing operation method for a resistive random access memory of claim 12, wherein the second preset count has the value N = 20.

14. A resistive random access memory, wherein the resistive random access memory is subjected to erasing in the erasing operation method for a resistive random access memory claimed in any one of claims 1 to 13.

15. A computing-in-memory chip, comprising the resistive random access memory of claim 14, wherein the resistive random access memory comprises a plurality of memory cells.

16. An electronic device, comprising the computing-in-memory chip of claim 15.
